Europäisches Patentamt

European Patent Office

Office européen des brevets

(11) Veröffentlichungsnummer: **0 406 678 A1**

# (12) EUROPÄISCHE PATENTANMELDUNG

(21) Anmeldenummer: 90112204.4

(22) Anmeldetag: 27.06.90

(51) Int. Cl.5: **C23C 18/20**

(30) Priorität: 06.07.89 DE 3922477

(43) Veröffentlichungstag der Anmeldung:
09.01.91 Patentblatt 91/02

(84) Benannte Vertragsstaaten:
**BE CH DE DK ES FR GB IT LI LU NL SE**

(71) Anmelder: **SCHERING AKTIENGESELLSCHAFT**
**Berlin und Bergkamen**
**Müllerstrasse 170/178 Postfach 65 03 11**
**D-1000 Berlin 65(DE)**

(72) Erfinder: **Riedl, Andrea**
**Hallesches Ufer 28**
**D-1000 Berlin 61(DE)**
Erfinder: **Tessmann, Detlef**
**Alt-Heiligensee 38 G**
**D-1000 Berlin 27(DE)**
Erfinder: **Bressel, Burkhard, Dr.**
**Kuno-Fischer-Strasse 13**
**D-1000 Berlin 19(DE)**

(54) Quellmittel zur Vorbehandlung von Kunstharzen vor einer stromlosen Metallisierung.

(57) Die Erfindung betrifft ein Quellmittel auf Basis eines Lösungsmittelsystems zur Vorbehandlung von Kunstharzen vor einer stromlosen Metallisierung, dadurch gekennzeichnet, daß dieses Glykolether enthält sowie die Verwendung dieses Quellmittels zur Herstellung von ganzflächig metallisiertem Basismaterial.

EP 0 406 678 A1

## QUELLMITTEL ZUR VORBEHANDLUNG VON KUNSTHARZEN VOR EINER STROMLOSEN METALLISIERUNG

Die Erfindung betrifft ein Quellmittel auf Basis eines Lösungsmittelsystems zur Vorbehandlung von Kunstharzen vor einer stromlosen Metallisierung sowie die Verwendung dieses Quellmittels zur Herstellung von ganzflächig metallisiertem Basismaterial.

Metallisierte Basismaterialien aus Kunstharzen werden für die verschiedensten Einsatzgebiete verwendet: zum einen wird aus verschiedenen Gründen die direkte Metallisierung von ebenen oder in komplexer Weise gestalteter Substratträger für Leiterzugstrukturen, wie sie zum Beispiel in Form der Leiterplatten für die Elektronikindustrie verwendet werden, gewünscht. Darüber hinaus ist es häufig nötig, elektronische Bauelemente gegen die Emission beziehungsweise die Immission von elektromagnetischer Strahlung abzuschirmen. Hierfür werden ebenfalls Metallschichten auf Kunstharzsubstrate durch elektrochemische Abscheidung aufgebracht. Weitere Anwendungsbereiche liegen in der dekorativen Ausgestaltung von Teilen für die Automobilindustrie oder für die Sanitarindustrie.

In allen genannten Fällen wird eine sehr innige Verbindung des Metallüberzuges mit der Harzunterlage angestrebt. Die geforderten hohen Haftungswerte, zum Beispiel meßbar mit dem Schältest, müssen unter Umständen auch nach thermischen Beanspruchungen (Löten der Leiterplatte) aufrecht erhalten bleiben.

In der herkömmlichen Technik werden Leiterplatten vorzugsweise nach der Subtraktivtechnik hergestellt. Hierbei kommen als Grundmaterial beidseitig mit dünner Kupferauflage versehene Epoxidharzplatten zum Einsatz, die häufig durch Glasfasernetzwerke im Innern verstärkt sind, in vielen Fällen jedoch auch Phenolharz-getränkte Papierlagen enthalten. Die Herstellung von Leiterplatten nach diesem Verfahren beinhaltet im wesentlichen die Metallisierung der für die .Aufnahme von Bauteil-Anschlußstiften oder für die elektrische Verbindung verschiedener Verdrahtungsebenen dienenden Bohrlöcher und der damit verbundenen Arbeitsschritte Bohrlochreinigung, -konditionierung, -aktivierung und -metallisierung.

Ein wesentlicher Nachteil des genannten Verfahrens besteht darin, daß die erforderlichen Ätzprozesse zur Herstellung der auf den Außenflächen der Leiterplatte liegenden Leiterzugstrukturen einerseits unwirtschaftlich sind, da das in Lösung gehende Kupfer entsorgt und wieder zurückgewonnen werden muß und andererseits wesentliche Restriktionen an die Feinheit der auf den Außenflächen der Leiterplatte erzeugten Leiterzugstrukturen (Breite und Abstand der Leiterbahnen) darstellen. Dieser zweite Punkt ist durch die nicht unerhebliche Unterätzung der Leiterzüge zu erklären, da die vollständige Dicke der auf das Grundmaterial auflaminierten Kupferfolie abgetragen werden muß. Aus technischen Gründen ist eine Untergrenze der Kupferfoliendicke von 17 μm nicht zu unterschreiten. Dünnere Kupferfolien haben sich in der Praxis nicht durchsetzen können, da derartig beschichtete Epoxidharz-Grundmaterialien nur schwierig herstellbar und damit teuer sind.

Darüber hinaus werden sehr hohe Anforderungen an die Konstanz des Ätzprozesses gestellt, wenn dickere Kupferschichten abgetragen werden müssen. Um diese Einschränkungen zu umgehen, kann man sich der Additiv- oder Semiadditivtechnik bedienen, bei denen von dem nicht mit Kupfer beschichteten Leiterplatten-Grundmaterial ausgegangen wird. Dasselbe gilt ohnehin für alle kompliziert geformten Kunstharzkörper, die metallisiert werden müssen, da in diesem Fall keine Kupferfolie bei der Herstellung des Substratkörpers auflaminiert werden kann, das heißt zum Beispiel im Falle der Abschirmung elektromagnetischer Strahlung oder bei der Herstellung kompliziert geformter Leiterzugstrukturen aufweisender Formkörper.

Derartige Techniken bei der Leiterplattenherstellung, deren Beherrschung neben der ordnungsgemäßen Bohrlochmetallisierung auch von der haftfesten Metallisierung auf den Außenflächen der Leiterplatte abhängt, werden in geringem Umfang mit solchen Grundmaterialien angewandt, die für die erwähnte ausreichende Haftung einen Haftvermittlerfilm tragen.

Ein erheblicher Nachteil dieser Materialien. der die Verbreitung der erwähnten Leiterplattenherstelltechniken stark behindert hat, besteht jedoch in der Anwendung der Haftvermittlerschicht:

Zum einen sind derartige mit Haftvermittlerschichten versehene Basismaterialien teuer. An die Haftvermittlerschicht werden erhebliche Qualitätsanforderungen in Bezug auf die Konstanz der Hafteigenschaften sowohl von Platte zu Platte als auch im mikroskopischen Bereich gestellt. Darüber hinaus hat sich eine erhebliche mechanische Empfindlichkeit der Haftvermittlerschicht herausgestellt, die leicht zu Beschädigungen der Basismaterialoberfläche führen.

Die Haftung des Haftvermittlerfilmes auf dem Leiterplatten-Grundmaterial wird häufig beanstandet, so daß ein ordnungsgemäßer Zusammenhalt des Gesamtverbundes Grundmaterial/Haftvermittler/Kupfer nicht in allen Fällen gewährleistet ist.

Diese Nachteile können dadurch umgangen werden, daß eine direkte Metallisierung nach geeigneter Vorbehandlung des Leiterplattengrundmaterials vorgenommen wird. Derartige Verfahren, die zum Beispiel einen oxidativen Aufschluß der Harzoberfläche in einer Cr(VI)- oder Permanganationen enthaltenden Lösung nach einem Quellschritt in einem organischen beziehungsweise anorganischen Lösungsmittel voraussetzen, sind an sich bekannt. Erfolgt im Anschluß an den oxidativen Angriff der Harzoberfläche eine Vorbehandlungs-/Bekeimungs-/Metallisierungssequenz nach herkömmlichem Muster, so werden festhaftende Metallschichten erhalten, die auch einer thermischen Belastung (zum Beispiel Eintauchen des metallisierten Substrats in ein Lötbad von 288 °C für 10 sec) ohne Schaden überstehen.

Die genannte Technik konnte sich jedoch nicht durchsetzen, da durch den oxidativen Angriff, der eine Aufrauhung des Grundmaterials nach sich zieht, Glasfasern des Verbundmaterials teilweise freigelegt werden. Dies führt in der Leiterplattenherstellung zu zwei nachteiligen Effekten, die so schwerwiegend sind, daß das Verfahren in dieser Weise nicht angewandt werden kann:

Zum einen ist die Haftung des Kupfers auf den Glasfasern außerordentlich gering, so daß lokale Defekte auftreten, die insbesondere bei sehr schmalen Leiterzügen schwerwiegende Folgen nach sich ziehen. Zum anderen können hervorstehende Glasfasern infolge der entstehenden Unebenheiten Probleme bei der Übertragung des Leiterbildes ergeben.

In verschiedenen Verbesserungen des beschriebenen Verfahrens wurden spezielle Grundmaterialien, insbesondere des Epoxidharztyps eingesetzt, um die beschriebenen Nachteile zu umgehen: Eine mögliche Alternative ist der Einsatz von sogenannten harzreichen Verbundlaminaten. Hierunter versteht man Füllstoff/Harz-Systeme, vorzugsweise Glasfaser/Harz-Systeme, deren Oberfläche einen höheren Anteil an Harzmasse bezogen auf das Gesamtvolumen und damit eine größere Harzdicke aufweisen. In diesem Fall wird auch ein stärkerer Ätzangriff die in größerer Tiefe liegenden Glasfasern nicht freilegen.

In einer anderen Variante wurden bei der Polymerisation stärker vernetzte Harze in Verbundmaterialien verwendet, wie sie zum Beispiel als mit difunktionellen oder tetrafunktionellen Anteilen versetzte Epoxidharze bekannt sind. In diesem Fall ist die Aufrauhung durch den Ätzangriff geringer und legt damit keine Glasfasern frei.

In beiden Fällen besteht der Nachteil darin, daß nur unter Verwendung spezieller Basismaterialsysteme gearbeitet werden kann, so daß die allgemeine Einsetzbarkeit des Verfahrens deutlich eingeschränkt ist. Wird harzreiches Material verwendet, kommt zusätzlich der allgemein zu beobachtende Nachteil hinzu, daß zur Erzeugung einer ausreichenden Haftfestigkeit eine starke Aufrauhung der Oberfläche vorgenommen werden muß. Dies hat mehrere schwerwiegende Nachteile:

Zum einen unterstützt eine starke Zerklüftung der Leiterplattenoberfläche die leichte Verunreinigung auf nicht metallisierten oder bereits durch Ätzen freigelegten Flächen. Dies wirkt sich zum Beispiel stark störend beim Abätzen des Kupfers während der Strukturierung aus. Durch diese Verunreinigungen können die Oberflächenwiderstandswerte deutlich beeinträchtigt werden. Ein weiterer Nachteil besteht bei Hochfrequenzanwendungen, da in diesem Fall durch den Skineffekt in nicht vorhersagbarer Weise starke Impedanzschwankungen zwischen den einzelnen Leiterzügen hervorgerufen werden können.

Auch in der Anwendung zur Abschirmung gegen elektromagnetische Strahlung ist eine starke Aufrauhung unerwünscht.

Aufgabe der vorliegenden Erfindung ist die Zurverfügungstellung eines Mittels, welches die Nachteile der übermäßigen Substratätzung bei gleichzeitig hoher Haftung des Materialfilms auf der Unterlage vermeidet und eine glatte Haftunterlage schafft, ohne daß auf die erforderliche Haftfestigkeit verzichtet werden muß.

Diese Aufgabe wird erfindungsgemäß durch ein Quellmittel gemäß dem kennzeichnenden Teil des Patentanspruchs gelöst.

Weitere Ausgestaltungen der Erfindung sind den Kennzeichnungsteilen der Unteransprüche zu entnehmen.

Zum Gegenstand der Erfindung gehören außerdem die Verwendung des Quellmittels zur Herstellung von ganzflächig metallisiertem Basismaterial sowie ein Verfahren zur Herstellung dieses Basismaterials.

Die erfindungsgemäß zu verwendenden Glykolether sind als solche bereits bekannt und nach an sich bekannten Verfahren herstellbar.

Herausragende Wirkungen im Sinne der Erfindung zeigen insbesondere
Diethylenglykoldimethylether
Triethylenglykoldimethylether
Tetraethylenglykoldimethylether
Diethylenglykoldiethylether

Die gekennzeichneten Glykolether werden zum Beispiel in wässrigen Lösungen in Anteilen von 0,1 bis 100 Gewichtsprozent, vorzugsweise in Anteilen von 20 bis 70 Gewichtsprozent. eingesetzt. Das Quellmedium kann in weiten Temperaturbereichen, vorzugsweise aber von Raumtemperatur bis zur Siedetemperatur des Quellmediums, eingesetzt werden.

Als Kunstharze können zum Beispiel Epoxidharze in den verschiedensten Ausführungsformen - wie die in der Leiterplattentechnik bekannten FR4-, FR5-Materialien mit und ohne mehrfunktionellen Zusätzen wie Phenol- und Kresol-Novolacken und tetrafunktionellen Materialien -, Bismaleintriazinharze und thermoplastische Substrate wie Acrylnitril/Butadien/Styrol-Copolymerisate, Polycarbonat und andere eingesetzt werden.

Der Ätzschritt erfolgt in oxidierenden Lösungen. Hierzu werden handelsübliche alkalische Permanganatlösungen, Chromsäurelösungen oder Chromschwefelsäurelösungen eingesetzt.

Alkalische Permanganatlösungen enthalten vorzugsweise Alkalisalze der Permangansäure, zum Beispiel Kalium- oder Natriumpermanganat in Konzentrationen von 30 g/Liter bis zur Sättigungsgrenze. Der Alkaligehalt wird vorzugsweise durch Zugabe von Alkalihydroxid, zum Beispiel Natriumhydroxid oder Kaliumhydroxid in Konzentrationen von 10 bis 200 g/Liter eingestellt. Die Betriebstemperatur dieser Ätzlösungen beträgt vorzugsweise von 40 bis 90 °C.

Chromsäurelösungen enthalten Chromtrioxid in Konzentrationen von 200 bis 900 g/Liter und werden bei Temperaturen von Raumtemperatur bis 90 °C eingesetzt.

Chromschwefelsäurelösungen werden üblicherweise als Beize für Acrylnitril/Butadien/Styrol-Copolymerisate eingesetzt. Zur Herstellung von Basismaterial gemäß der Erfindung werden sie in eben dieser Weise verwendet.

Eine Entfernung der Reste der Oxidationsmittel von der Harzoberfläche nach der Behandlung erfolgt je nach Oxidationsmittel mit sauren Lösungen von Reduktionsmitteln, wie sie üblicherweise in Metallisierungsverfahren eingesetzt werden.

Die Aktivierung erfolgt in üblicher Weise mit den bekannten Verfahren. Es können ionogene ebenso wie kolloidale Aktivatoren verwendet werden.

Die nachfolgende außenstromlose Metallisierung kann in einem beliebigen Metallisierungsbad erfolgen. Es kommen hierfür Kupfer-, Nickel-, Silber-, Gold-, Palladium-, Zinn- oder deren Legierungsbäder in Betracht. Die Metallisierungsschichtdicke beträgt etwa 0,05 μm bis etwa 60 μm und ermöglicht damit eine nachfolgende galvanische Metallisierung von sehr geringen bis zu beliebig gro ßen Schichtdicken.

Auf der ersten stromlos erzeugten Metallisierungsschicht können beliebige für den jeweiligen Verwendungszweck erforderliche Metallisierungsschichten aus anderen außerstromlosen oder galvanischen Elektrolyten aufgebracht werden, also zum Beispiel Kupfer-, Nickel-, Kobalt-, Zinn-, Blei-, Gold-. Palladium-, Silber-, Zink- oder deren Legierungsschichten.

Die erfindungsgemäß hergestellten Werkstücke werden für die unterschiedlichsten Verwendungszwecke eingesetzt: als Leiterzugstrukturen tragende Formkörper in der Elektronikindustrie, also zum Beispiel Leiterplatten, Chipträger, Hybridschaltungen, Steckverbinder und andere, als Abschirmung gegen die Emission oder Immission elektromagnetischer Strahlung oder andere Anwendungen.

Wird das erfindungsgemäß hergestellte Basismaterial zur Herstellung von Leiterplatten eingesetzt und vor der Metallisierung die für die Aufnahme der Bauteilstifte oder die elektrische Verbindung der verschiedenen Verdrahtungsebenen erforderlichen Bohrungen angebracht, so bieten sich vorzugsweise die Herstellvarianten der Semiadditiv- oder Additivtechnik an.

In der Semiadditivtechnik wird das unmetallisierte Material nach dem Bohren zunächst nach dem erfindungsgemäßen Verfahren ganzflächig metallisiert. Dabei werden Schichtdicken von ca. 5 μm appliziert. Anschließend erfolgt die Strukturierung des die Leiterzugstrukturen erhaltenden Formkörpers nach bekannten Verfahren (zum Beispiel Siebdrucktechnik oder Fotoverfahren). Die folgenden Arbeitsschritte werden nach bekanntem Muster durchgeführt.

In der Additivtechnik wird das unmetallisierte Material nach dem Bohren zunächst der Arbeitssequenz der Strukturierung nach bekannten Verfahren unterzogen. Anschließend erfolgt eine stromlose Metallisierung des Substrats nach dem erfindungsgemäßen Verfahren lediglich an den Stellen, an denen das fertige Halbzeug später Leiterzugstrukturen aufweisen soll. Denkbar ist auch, daß das Basismaterial nach dem Bohren zunächst nach dem erfindungsgemäßen Verfahren vorbehandelt wird und die Metallisierung und/oder Aktivierung erst nach der Strukturierung mit Galvanoresisten erfolgt.

Eine weitere Alternative besteht darin, das Basismaterial nach dem Bohren mit einer für Leiterzüge ausreichenden Metallschichtdicke ganzflächig zu metallisieren, um daran eine Strukturierung im Sinne der bekannten Tentingtechnik anzuschließen.

Alternativ kann ungebohrtes Material zunächst ganzflächig nach dem erfindungsgemäßen Verfahren mit einer dünnen Kupferauflage versehen werden. Anschließend werden die Bohrungen angebracht und daraufhin die bekannte Verfahrensweise der Subtraktivtechnik zur Erzeugung der Leiterzugstrukturen vorgenommen.

Die nachfolgenden Beispiele dienen zur Erläuterung der Erfindung.

BEISPIEL 1

Epoxidharz/Glasfaser-Laminate werden in üblicher Weise durch Verpressen von Prepregs unter Druck und Temperatur hergestellt. Im Unterschied zum konventionellen Verfahren wird jedoch an den Außenlagen keine Kupferfolie mit auflaminiert, sondern Prepregs. Gegen ein Verkleben mit dem Presswerkzeug wird auf beiden Seiten Fluorpolymerfolie aufgelegt.

Das fertige Laminat wird in folgendem Verfahrensablauf bis zu einer Kupferauflage von 5 $\mu$m beidseitig metallisiert:

1. Quellen in einer Lösung aus 45 Volumprozent Dimethylformamid, 20 Volumprozent Diethylenglykoldimethylether, 10 Volumprozent Ethylenglykol, 25 Volumprozent Wasser, 10 g NaOH/Liter (10 min, 30 °C),

2. Ätzen in einer Lösung aus 300 g $CrO_3$/Liter in Wasser (10 min, 70 °C),

3. Reduzieren anhaftender Cr(VI)-Ionenreste in einer $NaHSO_3$-Lösung,

4. Reinigen/Konditionieren in einer alkalischen Netzmittellösung mit einem kationischen Netzmittel,

5. Reinigen/Konditionieren in einer sauren Netzmittellösung mit einem kationischen Netzmittel,

6. Vortauchen in einer 10 ml-$H_2SO_4$-Lösung pro Liter,

7. Aktivieren in einer alkalischen Palladiumkomplexlösung,

8. Reduzieren in einer $NaBH_4$-Lösung.

9. Stromlos verkupfern (0,2 $\mu$m),

10. Galvanisch verkupfern (30 $\mu$m).

Zwischen den Arbeitsschritten 1., 2., 3., 4., 5., 6. beziehungsweise 7., 8., 9., 10. wird gespült.

Zur Haftungsmessung werden 1 cm breite Streifen des metallisierten Materials zurecht geschnitten und in einem Schältest die Haftungswerte gemessen. Man ermittelt Werte von 16 bis 20 N/cm.

## BEISPIEL 2

Das Beispiel 1 wird wiederholt. Jedoch wird vor der Haftungsmessung ein Thermoschock an der Versuchsprobe appliziert. Hierzu wird das metallisierte Substrat in ein Lötbad (SnPb) bei 288 °C für 10 sec vollständig eingetaucht und anschließend die Haftung gemessen. Man erhält Werte von 15 bis 20 N/cm.

## BEISPIEL 3

Das Beispiel 1 wird mit Diethylenglykoldiethylether statt Diethylenglykoldimethylether in derselben Konzentration unter Beibehaltung der übrigen Parameter im Queller und im gesamten Arbeitsablauf wiederholt. Man erhält Haftungswerte von 16 bis 18 N/cm.

## BEISPIEL 4

Das Beispiel 1 wird mit Triethylenglykoldimethylether wiederholt. Man erhält Haftungswerte von 16 bis 19 N/cm.

## BEISPIEL 5

Das Beispiel 1 wird mit Tetraethylenglykoldimethylether wiederholt. Man erhält Haftungswerte von 16 bis 19 N/cm.

## BEISPIEL 6

Das Beispiel 1 wird mit einem stromlos abscheidenden Dickkupferbad statt des Dünnkupferbades wiederholt. Nach der stromlosen Metallisierung erhält man ein mit 5 $\mu$m dicker blasenfreier stromloser Kupferauflage versehenes Substrat, das im galvanischen Bad weiterverstärkt wird. Die Haftungsmessung ergibt Werte von 14 bis 18 N/cm.

## BEISPIEL 7

Epoxidharz/Glasfaser-Prepregs werden zusammen mit durch eine übliche Technik strukturierten Innenlagen-Laminaten aus Epoxidharz/Glasfaser-Verbundmaterialien zu Mehrlagenschaltungen für Leiterplattenanwendungen unter Druck und Temperatur so verpreßt, daß Prepregs außen liegen. Gegen ein Verkleben mit dem Presswerkzeug wird auf beiden Seiten Fluorpolymerfolie aufgelegt.

Das Substrat wird nach einem vorgegebenen Muster mit unterschiedlich großen Bohrungen (von 0,6 bis 1,2 mm Durchmesser) versehen.

Anschließend wird nach dem Arbeitsablauf in Beispiel 1 metallisiert. Allerdings wird zwischen Schritt 5 und Schritt 6 eine Ätzreinigung der exponierten Stirnflächen der Kupferinnenlagen in den Bohrungen in einem Natriumpersulfat-haltigen Reiniger vorgenommen. Die galvanische Kupferschicht wird lediglich bis zu einer Gesamtdicke von 5 $\mu$m aufgebaut. Anschließend wird mit Hilfe eines Photoresists durch Auflaminieren des Filmes, Belichten der beschichteten Leiterplatte und Entwickeln eine Strukturierung vorgenommen. Die später als Kupferpartien vorkommenden Flächen werden hierbei als Kanäle auf der Kupferunterlage ausgeätzt. Anschließend wird weiter nach einer sauren Reinigung der exponierten Kupferflächen eine weitere galvanische Verkupferung bis zu einer Endschichtdicke von 35 $\mu$m vorgenommen. Der Galvanoresist wird gestrippt. Die dünnen Kupferflächen werden in einem Ätzbad (zum Beispiel $CuCl_2$-Ätze) entfernt und das Kupfer passiviert.

Man erhält eine Leiterplatte in sogenannter Kupfertechnik mit geringstem Ätzmittelverbrauch und vernachlässigbarer Unterätzung der Leiterzüge.

BEISPIEL 8

Derselbe Herstellungsvorgang wie in Beispiel 7 wird durchgeführt mit folgendem Unterschied:

Vor der Strukturierung wird eine Kupferschicht von 35 μm allseitig ganzflächig aufgebracht. Anschließend wird ein Tentingfilm auflaminiert, der als Ätzreserve dienen soll. Der Film wird belichtet und entwickelt. Anschließend wird das Kupfer von den exponierten Stellen weggeätzt, der Film wird gestrippt und das Kupfer passiviert.

Man erhält eine Leiterplatte in Kupfertechnik.

BEISPIEL 9

Für eine Anwendung zur direkten Montage von integrierten Halbleiterbausteinen auf Leiterplatten wird ein beidseitig mit 35 μm starker Kupferauflage laminiertes Basismaterial des Typs FR 5 mit quadratischen Aussparungen für die Aufnahme der direktmontierten Bauteile durch Ausfräsen vorbereitet. Eine flächige Metallisierung der gesamten Fläche (inklusive der Kupferkaschierung und der Bohrungen) wird nach dem Bohren der Platte mit Hilfe des in Beispiel 1 angegebenen Arbeitsablaufes vorgenommen. Um eine innige Verbindung mit dem Harz zu erreichen, wird mit einer 600 g-CrO₃-Lösung pro Liter anstelle der 300 g-CrO₃-Lösung pro Liter gearbeitet. Um zu verhindern, daß Oxidschichten auf den Kupferflächen eine haftfeste Verbindung mit der Auflage verhindern, wird vor der Vortauchlösung eine Ätzreinigung in einer Natriumpersulfat-haltigen Lösung vorgenommen.

Man erhält eine gute Haftung der naßchemisch abgeschiedenen Kupferschicht auf der Harzoberfläche, die auch nach einem Lötschock nicht abfällt.

BEISPIEL 10

Ein integrierter Halbleiterbaustein auf einem Chipträger wird in eine Epoxidharz-Gießharzmasse eingebettet. Für die elektromagnetische Abschirmung soll eine Kupfer/Nickel-Schicht haftfest aufgebracht werden.

Hierzu wird der in Beispiel 1 genannte Arbeitsablauf angewendet mit folgenden Unterschieden:

Die Ätzlösung in Schritt 2 enthält 600 g CrO₃/Liter in Wasser. Es werden lediglich 10 μm Kupfer mittels galvanischer Verstärkung aufgebracht. Anschließend erfolgt nach einer Aktivierung eine stromlose Beschichtung mit einer Ni/P-Legierung bis zu einer Gesamtschichtdicke von 20 μm.

Man erhält einen blasenfreien, haftfesten Überzug.

BEISPIEL 11

Das in Beispiel 10 genannte Substrat wird nach der dünnen stromlosen Verkupferung und nachfolgender Aktivierung mit einer 10 μm außenstromlos abgeschiedenen Ni/P-Schicht überzogen.

Man erhält eine blasenfreie, haftfeste Beschichtung.

BEISPIEL 12

Das in Beispiel 10 genannte Substrat wird direkt mit einer 10 μm außenstromlos abgeschiedenen Ni/P-Schicht überzogen.

Man erhält eine glatte, blasenfreie und haftfeste Beschichtung.

**Ansprüche**

1. Quellmittel auf Basis eines Lösungsmittelsystems zur Vorbehandlung von Kunstharzen vor einer stromlosen Metallisierung, dadurch gekennzeichnet, daß dieses Glykolether enthält.

2. Quellmittel gemäß Anspruch 1, worin die Glykolether Verbindungen der allgemeinen Formel
$R_1\text{-}(OCH_2.CH_2)_n\text{-}OR_2$
darstellen, in der $R_1$ und $R_2$ gleich oder verschieden sind und Alkyl-oder Arylreste bedeuten und n eine ganze Zahl von 1 bis 8, vorzugsweise von 1 bis 4, darstellt.

3. Quellmittel gemäß Anspruch 2, worin $R_1$ und $R_2$ gleich oder verschieden sind und Methyl, Äthyl, n-Propyl oder n-Butyl bedeuten.

4. Quellmittel gemäß Anspruch 1, dadurch gekennzeichnet. daß dieses
Diethylenglykoldimethylether,
Triethylenglykoldimethylether,
Tetraethylenglykoldimethylether oder
Diethylenglykoldiethylether
als quellend wirkende Mittel enthält.

5. Quellmittel gemäß Anspruch 1, enthaltend die Glykolether in Konzentrationen von 0,1 bis 100 Gewichtsprozent.

6. Quellmittel gemäß Anspruch 1, dadurch gekennzeichnet, daß dieses gegebenenfalls eine wässrige Lösung in Mischung mit organischen Lösungsmitteln darstellt.

7. Verwendung des Quellmittels gemäß Ansprüchen 1 bis 6 zur Herstellung von ganzflächig metallisiertem Basismaterial, vorzugsweise aus Epoxidharz, zweckmäßigerweise in Form von Platten.

8. Verfahren zur Herstellung von ganzflächig metallisiertem Basismaterial, gekennzeichnet durch die folgenden Verfahrensschritte:
- Vorbehandlung eines Kunstharz-Werkstückes mittels eines Quellmittels gemäß Anspruch 1.
- Ätzen in einer oxidierenden Ätzlösung.
- Entfernen der Reste des Oxidationsmittels vom Werkstück.
- Aktivieren der Werkstück-Oberfläche.
- Stromlose Metallisierung der Werkstoff-Oberfläche.

9. Verfahren gemäß Anspruch 8, dadurch gekennzeichnet, daß das Kunstharz-Werkstück mehrschichtig aufgebaut ist und aus alternierenden Lagen von mit unter Wärme und unter Druck ausgehärteten Epoxidharz-getränkten Glasfasermattenschichten und Kupferlagen besteht.

10. Verfahren gemäß Anspruch 8, dadurch gekennzeichnet, daß die stromlose Metallisierung mittels eines stromlosen Kupferbades erfolgt.

11. Verfahren gemäß Anspruch 8, dadurch gekennzeichnet, daß die Vorbehandlung bei Temperaturen von etwa 20 °C bis zur Siedetemperatur des Lösungsmittelsystems erfolgt.

12. Verfahren gemäß Anspruch 8, dadurch gekennzeichnet, daß als oxidierende Ätzlösung eine Lösung enthaltend Permanganat-Ionen, wie eine alkalische Permanganat-Lösung, oder Chrom-IV-Verbindungen, wie Chromtrioxid, verwendet wird.

13. Ganzflächig metallisiertes Basismaterial, hergestellt gemäß Verfahren nach den Ansprüchen 8 bis 12.

14. Verwendung des ganzflächig metallisierten Basismaterials gemäß Anspruch 13 zur Herstellung von Leiterplatten, Chipträgern, Hybridschaltungen, mehrschichtigen mit Kupfereinlagen versehenen Laminat-Halbzeugen sowie von Halbzeugen zur elektromagnetischen Abschirmung von elektrischen Schaltungen und Komponenten.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | WO-A-8 700 391  (ENTHONE INC.)<br>* Seite 8, Zeilen 9-33; Seite 9, Zeilen 20-33 *<br><br>– – – | 1,2,3,5,6,<br>7,8,10,11,<br>12,13,14 | C 23 C 18/20 |
| X | FR-A-2 222 459  (MITSUBISHI GAS CHEMICAL CO.)<br>* Seite 10, Patentansprüche 1,2,8 *<br><br>– – – – – | 1,2,3,5,7,<br>8,9,10,11,<br>12,13 | |

**RECHERCHIERTE SACHGEBIETE (Int. Cl.5)**

C 23 C

Der vorliegende Recherchenbericht wurde für alle Patentansprüche erstellt

| Recherchenort | Abschlußdatum der Recherche | Prüfer |
|---|---|---|
| Den Haag | 22 Oktober 90 | NGUYEN THE NGHIEP |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

&: Mitglied der gleichen Patentfamilie, übereinstimmendes Dokument